# EUROPEAN PATENT SPECIFICATION

(11) **EP 1 129 821 B1**
(45) Date of publication and mention of the grant of the patent: **21.05.2008**
(21) Application number: 00953541.0
(22) Date of filing: 21.08.2000
(51) Int. Cl.: B24B 37/00, H01L 21/304, B24D 13/14, B24B 37/04, B24D 3/26

(54) **METHOD AND DEVICE FOR POLISHING SEMICONDUCTOR WAFER**
VERFAHREN UND VORRICHTUNG ZUM POLIEREN VON HALBLEITERSCHEIBEN
PROCEDE ET DISPOSITIF DE POLISSAGE POUR TRANCHE DE SEMICONDUCTEUR

(30) Priority: 31.08.1999 JP 24624399
(43) Date of publication of application: 05.09.2001
(73) Proprietor: Shin-Etsu Handotai Co., Ltd., Tokyo (JP)
(72) Inventor: KOBAYASHI, Makoto, Nishishirakawa-gun, Fukushima 961-8061 (JP); TAKAMATSU, Hiroyuki, Nishishirakawa-gun, Fukushima 961-8061 (JP)
(74) Representative: Cooper, John
(86) International application number: PCT/JP2000/005595
(87) International publication number: WO 2001/015860

(56) References cited:
- EP-A- 0 933 166
- JP-A- 5 129 257
- JP-A- 8 300 252

## Description

### Technical Field

The present invention relates to a mirror polishing process for a semiconductor wafer (hereinafter, may be simply referred to wafer), especially to a polishing pad and polishing method used in a finish polishing as a final step of polishing process for a semiconductor wafer. An example of such a process is disclosed in EP-A-933166, which discloses a pad according to the preamble of independent claim 1.

### Background Art

Recently, with an ultra-miniaturization and higher integration of semiconductor devices, it is desired that a surface of a semiconductor wafer consisting of silicon or the like is made flat with high precision. Accordingly, a mirror polishing is performed as a process means for answering the above-described desire. By such a mirror polishing for a semiconductor wafer, the wafer is processed to have a smooth and non-damage mirror-polished surface.

As a conventional method for processing a semiconductor wafer, there have been generally performed a slicing step for slicing thin plates (wafers) from a single crystal ingot, a chamfering step for preventing a chipping in a peripheral portion of the wafer, a lapping step or surface grinding step for reducing the ununiformity of the thickness of a wafer, an etching step for eliminating mechanical damages and contaminants, a mirror-polishing step for mirror-surfacing a chamfered portion and main surface of a wafer and the like sequentially.

The mirror polishing for a silicon wafer is performed by applying a constant load and relative speed between the wafer and polishing pad while supplying a polishing agent. For example, in the case where a single-side polishing apparatus polishes a semiconductor wafer, the polishing apparatus is mainly composed of a turn table, wafer holder, and polishing agent supply unit. The turn table, on which a polishing pad is attached, is rotated at a predetermined rotation speed via a rotary shaft. On the other hand, the structure of the wafer holder is that it holds a wafer by means of vacuum sucking, wax or the like, to face a polishing pad attached on the turn table and presses the wafer against the polishing pad with a predetermined load while rotated via a rotating shaft. The polishing agent supply unit supplies a polishing agent, which is made by dispersing a calcined silica, colloidal silica or the like in a alkaline solution, onto the polishing pad at a predetermined flow rate, and during polishing, the wafer is mirror-polished by supplying the polishing agent between the wafer and the polishing pad.

As to mirror-polishing process, in addition to the above-described single-side polishing apparatus, a double-side polishing apparatus has also been employed, which can make both sides of a wafer simultaneously like a lapping process to be mirror-surface.

Further, as to wafer holding type, in addition to the above-described types by means of vacuum sucking and a wax type which holds a wafer with adhesive such as wax, a wax free (waxless mount) type which holds a wafer with a backing pad and template has been also employed. As to the number of wafers to be processed, a so-called batch processing type, which polishes multiple wafers simultaneously, or a single wafer processing type, which polishes wafers one by one, has been employed. As described above, several processes and types for the mirror polishing have been suggested from several viewpoints.

Although any process or type as described above has been employed, the mirror-polishing process is generally performed under two or more steps. In a rough polishing of the early step, called a first polishing, the polishing is performed with a hard polishing pad at a comparatively fast polishing rate so as to reduce the ununiformity of the thickness of the wafer after polishing.

However, in the polishing of the early step, there are likely to remain the ununiformity of surface roughness, a cloudiness so-called haze, for example, and polishing damage, which becomes an issue on the subsequent device fabrication process, on the wafer. Accordingly, in general, a finish polishing process is finally performed so that the ununiformity of surface roughness which remains on the wafer surface is eliminated to complete it as an entire mirror-polished wafer.

In the early step of the polishing, that is, a first polishing etc., a polishing pad which comprises a foamed urethane sheet, or a polishing pad (velour type) formed by impregnating urethane resin into a nonwoven fabric such as polyester in order to harden it, is generally used. Further, in a final finish polishing, a suede-type polishing pad is used. This is as a sort of artificial leather for industrial materials, and the polishing pad, which comprises a base layer consisting of a nonwoven fabric formed of a synthetic resin, special synthetic rubber or the like, and a surface layer consisting of a resin with high wear resistance such as polyurethane and having minute pores formed therein, is used. The back surface of the base layer is bonded to a turn table with an adhesive double coated tape or the like as a bond layer.

Incidentally, with a recent increase in the degree of integration of semiconductor devices, the requirement for the surface characteristic of wafers after mirror-polishing process has became strict. For example, in addition to the above-mentioned flatness of the wafer, it has been required that even minute defects and scratches on the wafer surface should not exist.

When the mirror-polishing process is performed, minute damages or scratches may be generated on the wafer surface, especially, in the early polishing step such as a first polishing process, such polishing damages or scratches are likely to be generated by using a hard polishing pad or polishing agent having high polishing performance. However, in the subsequent finish polishing, the wafer is polished on the condition to eliminate damages, scratches or the like, which remain even after the first polishing as described above.

After the finish polishing, if there exist still scratches or the like on the wafer surface, they are detected by a common visual inspection under collimated light, and the detected wafer is rejected as a defective product. However, it is difficult to detect polishing damages by the visual inspection under collimated light. Therefore, after the finish polishing, even if such damages exist on the wafer, they can not be detected on the wafer surface, and thus the wafer has been regarded as a non-defective product.

Further, even in a device fabrication stage, such a wafer condition, that is, minute damage which exists after finish polishing and can not be detected by a visual inspection, has been disregarded as having no harmful effects especially for quality (device characteristic).

However, with a recent additional increase in the degree of minuteness of devices, it has been suggested that these damages may cause the problems in the device fabrication process. In short, it has been observed lowering yield and generating defects of unknown origin.

On the other hand, an evaluation technique for wafer surface conditions has been improved, and as the result, the polishing damages which could not be detected in the past can be detected at present. According to this evaluation method, it is found that when the polishing is performed with a polishing pad for a finish polishing, which has been used conventionally, there are some cases where polishing damages generate on the wafer surface. Judging from this, it is suggested that these polishing damages may affect a device yield for any reason. Its detailed action has not been revealed, but it has been revealed that a minute damage generated in a finish polishing process turns into some defect nucleus, and it has a potential for causing a failure of a semiconductor device.

The following results can also be obtained that the polishing damages which remain on a wafer after a finish polishing can not be reduced, even if polishing time or the like is increased, and if anything, the finish polishing time is longer, the generation of damages are rather increased. Therefore, it was found that not so much the polishing damages generated in the first polishing process remain without being eliminated due to insufficient polishing as new polishing damages generate in the finish polishing process.

As described above, the polishing damages generated in the finish polishing process to complete a high quality wafer, which is suitable for a recent high-integrated semiconductor device, are a particular problem.

### Disclosure of the Invention

The present invention has been accomplished in view of the above-mentioned problems, and an object of the present invention is to provide a polishing pad and polishing method to obtain a mirror-polished wafer without generating polishing damages in a mirror-polishing process of a semiconductor wafer, especially in a finish polishing.

In order to achieve the above object, a polishing pad having the features of claim 1 and a polishing method according to claim 9 are provided. The present invention specifies the content of zinc compounds included in a polishing pad so as not to generate polishing damages in a mirror-polishing process. Zinc weight relative to the weight of a polishing pad, used in the present invention, means weight of zinc which constitutes zinc compounds included in the polishing pad/weight of the polishing pad, as long as it has no particular notice.

The present invention provides a polishing pad used for mirror-polishing a semiconductor wafer, wherein a content of zinc compounds included in the polishing pad is 200ppm or less at the ratio of zinc weight relative to the weight of the polishing pad.

As described above, if the polishing pad, in which the content of zinc compounds included is 200ppm or less at the ratio of zinc weight relative to the weight of the polishing pad, is used in a mirror-polishing, the polishing damages generated in the mirror-polishing can be suppressed, and accordingly the wafer having almost no problem in the subsequent device fabrication process can be manufactured.

Also, the present invention provides a polishing pad used for mirror-polishing a semiconductor wafer in a finish polishing process, wherein a content of zinc compounds included in the polishing pad is 100ppm or less at the ratio of zinc weight relative to the weight of the polishing pad.

As described above, if the polishing pad, in which the content of zinc compounds included is defined to a less extent as 100ppm or less at the ratio of zinc weight relative to the weight of the polishing pad, is used to eliminate cloudiness and polishing damages in the finish polishing, the polishing damages generated in the finish polishing are further suppressed and accordingly the wafer having almost no problem in the subsequent device fabrication process can be manufactured.

Further, the present invention provides a polishing pad used for mirror-polishing a semiconductor wafer in a finish polishing process, wherein the polishing pad does not include zinc compounds.

As to the polishing pad used for the finish polishing, it is preferable that the polishing pad includes zinc compounds as little as possible, and therefore, use of the polishing pad including no zinc compounds as described above can suppress the generation of polishing damages.

Furthermore, it is preferable that the polishing pad according to the present invention in which the content of zinc compounds is controlled comprises a base layer consisting of a nonwoven fabric and a porous surface layer.

As described above, by using the polishing pad which comprises a base layer consisting of a nonwoven fabric and a porous surface layer, in the case of a polishing, the polishing can be preferably performed without causing the polishing damages on a wafer surface due to zinc compounds in the polishing pad.

In this case, the polishing pad is more preferred such that the content of zinc compounds included in the surface layer is 100ppm or less at the ratio of zinc weight relative to the weight of the surface layer.

As described above, it is preferable that the polishing pad includes zinc compounds as little as possible. However, zinc compounds which actually cause polishing damages are included in the portion where the polishing pad is in contact with a wafer, that is, zinc compounds included in the surface layer of the polishing pad cause polishing damages. Therefore, it is important that zinc compounds included in the surface layer of the polishing pad should be less.

As described above, by using the polishing pad in which the content of zinc compounds included in the surface layer of the polishing pad is 100ppm or less at the ratio of zinc weight relative to the weight of the surface layer, zinc compounds which exist in the contact portion with a wafer can be certainly reduced, and in the case of polishing, the polishing can be performed more preferably without causing the polishing damages on a wafer surface.

As to the content of zinc compounds in the base layer, it is not limited in particular as long as the content of zinc compounds included in the surface layer is 100ppm or less at the ratio of zinc weight relative to the weight of the surface layer. However, it is preferable that the content of zinc compounds in the base layer as well as in the surface layer is as little as possible. By the way, it is preferable in particular that the surface layer does not include zinc.

Further, it is preferable in particular that the surface layer is formed of foamed polyurethane. A conventional polishing pad including urethane resin suffers from a problem that it is likely to include zinc compounds in particular. On the contrary, as described above, by using the polishing pad which has a surface layer formed of polyurethane and is controlled in terms of the content of zinc compounds in the entire polishing pad or the surface layer of the polishing pad, the wafer having very little damages can be manufactured. Also, since the surface layer is formed of foamed polyurethane, the mirror polishing of high surface precision and the finish polishing of high surface precision, such as removal of cloudiness, can be preferably performed.

Furthermore, the present invention provides a method for polishing a semiconductor wafer using the aforementioned polishing pad. If the polishing pad specified in terms of the content of zinc compounds as aforementioned is applied to the mirror polishing of a semiconductor wafer, especially to the finish polishing, the semiconductor wafer which has almost no damages and which is suitable for fabricating a high-integrated semiconductor device can be manufactured.

Additionally, the present invention provides a polishing method for a semiconductor wafer, wherein a finish-polishing in a mirror-polishing of the semiconductor wafer is performed on the condition that the concentration of zinc compounds in the position where the semiconductor wafer is in contact with the polishing pad is 200ppm or less.

As aforementioned, the mirror polishing of a semiconductor wafer is generally performed stepwise so that a finish polishing is performed after a rough polishing such as a first polishing. However, if zinc compounds are included in the finish polishing, in what way, for example, from a polishing agent, damages are obliged to generate. That is, the problem lies in the fact that zinc compounds exist between a polishing pad and wafer. Therefore, as described above, if a finish-polishing is performed on the condition that the concentration of zinc compounds in the position where a semiconductor wafer is in contact with the polishing pad is 200ppm or less, the semiconductor wafer suitable for fabricating high integrated semiconductor devices can be produced without the generation of polishing damages.

That is, the content of zinc compounds present in the polishing agent or polishing pad is reduced to the utmost, in fact, the less content of zinc compounds is more preferable. Specifically, when the concentration of zinc compounds in the position where a semiconductor wafer is in contact with the polishing pad is 200ppm or less, the polishing damages, which may cause the generation of defects or low yield in the subsequent device fabrication step, can be suppressed.

It is clear from the above explanation that the content of zinc compounds in the polishing pad or the concentration of zinc compounds in the portion where the polishing pad is in contact with a wafer during the polishing is controlled at a certain amount or less, so that a high quality wafer having very few polishing damages can be manufactured.

Further, thus manufactured wafer having very few polishing damages can be applied to fabrication of recent high-integrated devices. By using this wafer, the generation of defects and low yield in the subsequent device fabrication step can be improved.

Furthermore, by reducing the content of zinc compounds, a processing time of a polishing pad in start-up can be reduced, and as the result, operating efficiency can be increased.

### Brief Description of the Drawings

FIG. 1 is a graph representing the relation between the number of etching and ratio of LPD in terms of each polishing pad used in the examples and comparative example.
FIG. 2 is a schematic cross sectional view showing one example of a polishing pad used in a finish polishing.
FIG. 3 is a schematic view showing a structure of polishing portion of a single-side polishing apparatus for mirror-polishing a surface of a semiconductor wafer.

### Best Mode for Carrying out the Invention

An embodiment of the present invention will now be described.

The present inventors found that minute polishing damages were generated by using a conventional finish polishing pad in a mirror-polishing process of a semiconductor wafer, examined the polishing damages generated in the polishing process, and found that some contaminants were included in the polishing pad. These contaminants, were identified by Energy Dispersive X-ray Spectroscopy (abbreviated name, EDX), as the result, zinc (Zn) and oxygen (O) were detected, and it was found that these contaminants were zinc compounds. Further, it was revealed that a wafer polished by a polishing pad having more zinc compounds was likely to generate more surface defects than a wafer polished by a polishing pad having less zinc compounds.

Consequently, the inventors investigated the inclusion of zinc compounds, and found that zinc compounds were added to a polishing pad for controlling its characteristic in manufacturing thereof. For example, zinc compounds are added to a polishing pad for increasing hardness of a nonwoven fabric constituting the polishing pad. Additionally, zinc compounds were added to a polishing pad formed of urethane resin as a stabilizer against light in a manufacturing step of urethane resin, and it was found that not a little zinc compound were included into the polishing pad manufactured based on the above urethane resin. Conventional polishing pads investigated this time included zinc compounds of several hundred ppm.

This zinc compound is mainly composed of zinc oxide (ZnO), and its grain diameter is about 500nm to 1000nm. It was revealed that if such zinc compounds are included in a polishing pad, the generation of surface defects on a wafer is accelerated when the wafer surface is polished by using the polishing pad.

A zinc compound is generally a softer substance than silicon, which is used as a raw material of a semiconductor wafer. That is, indicating by Mohs hardness, the hardness of silicon (Si) as a polished material is 7, silica (SiO₂) of a polishing agent is 7, and zinc compound (ZnO) is 4. Therefore, as to hardness, since silicon is harder than zinc compound, it seemed difficult to generate scratches due to the zinc compound, so that it has not been studied the influence of zinc compound in the polishing.

However, the present inventors devoted themselves to investigation on the influence, and revealed for the first time that although each wafer surface has no visible scratches so far as the detection by a visual inspection under collimated light or the like, each wafer surface is differently damaged in accordance with the difference of the content of zinc compounds in each polishing pad.

Further, it is considered that this damage functions as a defect nucleus in the subsequent step, and leads to generation of defects which may lower dielectric breakdown strength of oxide film or affect yield.

Consequently, the present invention provides a polishing pad for semiconductor wafer, wherein the content of zinc compounds thereof is controlled.

First, with reference to the drawings, there will be described one example of a mirror-polishing apparatus to which a polishing pad for semiconductor wafer according to the present invention can be applied.

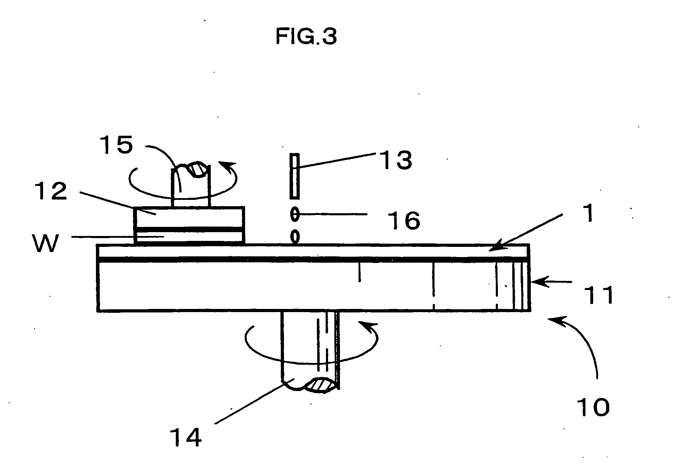

FIG. 3 is a schematic view showing a structure of polishing portion of a single-side polishing apparatus. The single-side polishing apparatus as shown in FIG. 3 is constructed to polish a single side of a semiconductor wafer, for example, and as shown in the drawing, the polishing portion 10 of the polishing apparatus generally comprises a turn table 11, wafer holder 12 (sometimes called head), and polishing agent supply unit 13. A polishing pad 1 is applied to the top surface of the turn table 11, and the polishing pad 1 together with the turn table 11 is rotated by a rotary shaft 14 at a predetermined rotating speed.

And, the wafer holder 12 holds a wafer W with vacuum sucking, wax, or the like so that the wafer faces the polishing pad on the turn table, and presses the wafer W against the polishing pad 1 at a predetermined load in parallel with the rotation of the rotating shaft 15.

The polishing agent supply unit 13 supplies a polishing agent 16 onto the polishing pad 1 at a predetermined flow rate, and the polishing agent 16 is supplied between the wafer W and polishing pad 1, so that the wafer W is polished smoothly.

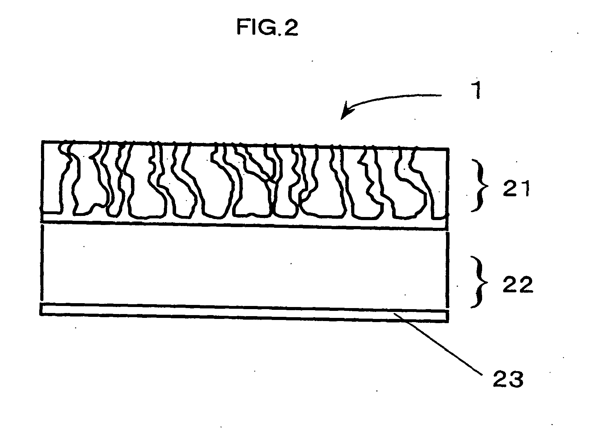

Next, one example of a polishing pad used for mirror polishing will now be described with reference to FIG. 2.

The polishing pad 1, which is used for mirror-polishing the surface of a semiconductor wafer with aforementioned single-side polishing apparatus, for example, is a suede-type polishing pad for finish-polishing comprising a base layer 22 formed of nonwoven fabric and porous surface layer 21 (the surface layer 21 sometimes called a nap layer) formed on the base layer 22. This polishing pad is adhered to the turn table 11 as shown in FIG. 3 through a bond layer 23 such as adhesive double coated tape. By the way, when the polishing is performed, as aforementioned, the wafer W held by the wafer holder 12 is polished by being pressed onto the polishing pad 1 with a predetermined load while the polishing agent 16 is supplied onto the polishing pad 1 rotated at a predetermined rotation speed.

A polishing pad for semiconductor wafer according to the present invention is characterized in that the content of zinc compounds included in the polishing pad is 200ppm or less at the ratio of zinc weight relative to the weight of the polishing pad. Such a polishing pad is used for mirror-polishing a semiconductor wafer, so that polishing damages which may be generated in mirror-polishing are suppressed, and therefore, the wafer having almost no trouble for the subsequent device fabrication step can be manufactured.

Besides, specifically, when mirror-polishing is performed stepwise, that is, when a finish polishing is performed after rough-polishing such as a first polishing and second polishing, polishing damages can be eliminated more certainly in the finish polishing by using a polishing pad in which the content of zinc compounds is 100ppm or less at the ratio of zinc weight relative to the weight of the polishing pad, so that the wafer having almost no problem in the subsequent device fabrication step can be manufactured.

Further, it is preferable that the polishing pad includes zinc compounds as little as possible, and if a polishing pad having no zinc compounds is used for a finish polishing, polishing damages due to zinc compounds are not generated completely, and therefore, the wafer can be suitable for high-integrated semiconductor devices.

As to material and structure of the polishing pad, any polishing pad used conventionally can be available, however, considering elimination of cloudiness on the wafer surface after polishing, it is preferable to use a suede-type polishing pad comprising a base layer consisting of nonwoven fabric and porous surface layer as shown in FIG. 2. Such a polishing pad, which is formed of the base layer and surface layer and is controlled in terms of the content of zinc compounds, is used for mirror-polishing of a semiconductor wafer, specifically, finish polishing thereof, so that the semiconductor wafer can be finished without cloudiness, and besides without polishing damages which may become defect nuclei. And thus obtained wafer can be advantageously used in the subsequent device fabrication process.

Furthermore, as described above, the content of zinc compounds in the polishing pad comprising a base layer consisting of nonwoven fabric and a porous surface layer is preferably as little as possible in both the base layer and surface layer, especially, rather preferably as little as possible in the surface layer, and specifically, the content of zinc compounds included in the surface layer is 100ppm or less at the ratio of zinc weight relative to the weight of the surface layer.

When a mirror polishing of a wafer is performed by using the polishing pad according to the present invention, only a surface layer of the polishing pad is actually in contact with the wafer surface to polish it. Therefore, the existence of polishing damages depends largely on the content of zinc compounds in the portion where the polishing pad is in contact with the wafer, that is, in the surface layer. Therefore, for example, even if the content of zinc compounds included in the polishing pad is more than 100ppm at the ratio of zinc weight relative to the weight of the polishing pad, but if the content of zinc compounds in the surface layer thereof is 100ppm or less, the very excellent wafer having no polishing damages can be completed. In this case, it needs an attention so that zinc compounds should not be transferred from the base layer to the surface layer.

The material of the surface layer is not limited as far as it has been conventionally used as a polishing pad, but foamed polyurethane is preferred in particular. For example, if a nonwoven fabric, which has been conventionally employed, is used as the base layer, and the surface layer consists of foamed polyurethane, coupled with the limitation of the content of zinc compounds included in the polishing pad or surface layer thereof, a mirror polishing of a semiconductor wafer, especially a finish polishing of a silicon wafer can be preferably performed, and thereby the wafer can be finished without polishing damages.

The polishing pad according to the present invention is controlled in terms of the content of zinc compounds included in the polishing pad as aforementioned, and if such a polishing pad is used for mirror-polishing, especially for finish-polishing, the wafer having no polishing damages can be obtained. And, it is considered that thus effect comes from keeping the concentration of zinc compounds to a certain rate or less in the portion where the polishing pad is in contact with a wafer. Therefore, if a mirror polishing, especially a finish polishing is performed on the condition that the concentration of zinc compounds in the portion where the polishing pad is in contact with the wafer is suppressed to a certain rate or less, the wafer having no polishing damages can be obtained.

In a common finish polishing process, it is very rare case that zinc compounds come from outside. Therefore, if only the content of zinc compounds in the polishing pad is limited, the concentration of zinc compounds in the portion where the polishing pad is in contact with the wafer can be suppressed to a certain rate or less, and the wafer can be preferably polished. In this case also, it is preferable that the polishing pad includes zinc compounds as little as possible, but even if there is a factor from outside except the polishing pad, if a finish polishing is performed on the condition that the concentration of zinc compounds in the portion where the polishing pad is in contact with a semiconductor wafer is collectively 200ppm or less, the same effect as described above, that is, the wafer having no polishing damages can be obtained.

As described above, the polishing pad and polishing method according to the present invention are applied to a mirror polishing of a semiconductor wafer, especially to a finish polishing, so that the wafer can be finished without polishing damages. Further, when the resultant wafer is used, the generation of failure in the subsequent device fabrication step can be suppressed.

Furthermore, since the polishing pad according to the present invention is hyhrophilic because of low content of zinc compounds, working effeciency can also be improved in the beginning step of using the polishing pad. Generally, in the beginning step of using a polishing pad for a finish polishing or the like, first, a start-up process (sometimes called a dummy polishing) is performed to make the surface layer of the polishing pad familiar with polishing agent or water and makes better contactability between the wafer and polishing pad in polishing, and thereby accuracy of a mirror-surface process is improved. However, the polishing pad according to the present invention, as mentioned above, is hyhrophilic, so that it is easy to become familiar with water, and the start-up process time can be reduced. Therefore, working efficiency, especially in the beginning step of polishing pad, is improved, and the whole polishing operation time is also reduced.

By the way, the polishing pad and polishing method according to the present invention are applicable to apparatuses or manners, not limited in particular, as far as they are used for mirror-polishing a semiconductor wafer. For example, besides a single-side polishing method, double-side polishing method can also be used. Further, the present invention is not especially limited to any wafer holding method, and thus any types of a vacuum sucking type, wax type or wax free type can be adopted, and a batch type process, by which multiple wafers are polished at once, or a single wafer processing method, by which a wafer is polished one by one, can be also applied. As described above, apparatuses of various methods and types performed in mirror polishing can be applied.

Further, the present invention is not also limited in a semiconductor wafer to be polished in particular, but specifically can be applied to a silicon single crystal wafer preferably.

Incidentally, the present invention is adapted to a common wafer process, that is, a finish polishing in a multi-step polishing process, however, as examples except such a finish polishing, the present invention can also be applied to a polishing for a wafer processed by PACE (Plasma Assisted Chemical Etching) technique which is a thinning method different from grinding and polishing and has been developed in recent years, or by hydrogen ion delaminating method (sometimes called a smart cut method) which has been suggested as a thin SOI (Silicon On Insulator) film manufacturing technique. Since the mirror surface condition of a wafer is slightly degraded after hydrogen ion delamination or by performing PACE process, a light polishing called touch polishing whose stock removal is about tens of nm is performed. It is preferable that polishing damages are not existed also in such processes, and therefore the polishing pad of the present invention can be applied thereto.

Hereinafter, the present invention will now be specifically described, giving examples and comparative example; however, the present invention is not limited thereto.

It becomes a problem that damages remain on a wafer surface especially before device fabrication step, that is, after a finish polishing so as to attain the final quality of a wafer.

Accordingly, in the following examples and comparative example, a silicon single crystal wafer (diameter/150mm and thickness/625*µ*m) after a first polishing was used as an example to be polished, and the influence of zinc compounds in the finish polishing was determined.

A polishing pad, in which a base layer consists of a nonwoven fabric having a thickness of about 1000*µ*m and formed by impregnating a polyester felt with polyurethane, a polyurethane was coated (laminated) on the base layer, a foam layer was grown in the polyurethane, and a surface portion of the foam layer was eliminated to form openings in the foam layer thereby forming a nap layer having a thickness of about 450 *µ*m, was used.

### Example 1 and Example 2

The content of zinc compounds in polishing pads were adjusted (reduced) by changing an additive amount of zinc compounds to the surface layer in manufacturing the polishing pad. According to such a method, the polishing pads in which the content of zinc compounds included in a surface layer of the polishing pad was 40-100ppm at the ratio of zinc weight relative to the weight of the surface layer in the polishing pad were obtained. In the present examples, two kinds of polishing pads that one was 99ppm at the ratio of zinc weight relative to the weight of the surface layer of the polishing pad (polishing pad A; Example 1), and the other was 78ppm (polishing pad B; Example 2) were used, and the influence of zinc compounds in a finish polishing was determined.

As to zinc weight relative to the weight of the surface layer of the polishing pad, the surface layer of the polishing pad was decomposed with a microwave (MW), and the weight was determined by an atomic absorption.

Specifically, a foamed polyurethane in a surface layer of the polishing pad was cut off (sampling) by 10mg with a ceramic cutter, the sample was dissolved by using a MW decomposing apparatus (made by Perkin-Elmer Corporation) with HNO₃ of 6mL used as a resolvent solution, and after that, the content of zinc (Zn) was determined by an atomic absorption apparatus (made by Perkin-Elmer Corporation, SIMAA 6000).

The lower limit of detection in the atomic absorption apparatus itself was about 10ppb, the lower limit of detection under this evaluation method as a whole (the lower limit value of reliable values obtained by repeated measurements, for example), which varied with the quantity of sampling, or the quantity of dilution in analysis, is about 10ppm. By the way, the content of Zn determined here was expressed in a formula [zinc weight constituting zinc compounds included in the sampled surface layer of the polishing pad/weight of the sampled surface layer of the polishing pad]. Hereinafter, this may be merely called zinc content in a surface layer.

Further, zinc weight relative to total weight of a polishing pad including a base layer was determined by the same method as aforementioned except a measurement example which was obtained by cutting out, not only a foamed polyurethane of its surface layer, but a polishing pad as a whole including its base layer with a ceramic cutter. That is, after dissolving the sample by a microwave, its solution was determined by an atomic absorption.

The zinc content in the polishing pad measured by this method was 255ppm in the polishing pad A and 195ppm in the polishing pad B.

As for polishing condition, a single-side polishing apparatus as shown in FIG. 3 was used, and polishing was performed at a polishing load of 100g/cm², head rotation number of 80rpm, and turn table rotation number of 80rpm while supplying a colloidal silica (particle diameter/about 80nm, silica concentration/ 2.5 weight %, and pH/10.5) used as a polishing agent at 150cc/min. The polishing time was 10 minutes, and the stock removal was about 0 .1 µm.

Defects (polishing damages) on a wafer surface were evaluated after polishing the wafer. The evaluation of defects on a wafer surface was performed by processing it with an ammonia-type processing liquid, and then observing the number of LPD (Light Point Defect). This is the evaluation method by utilizing a phenomenon that when there are defects such as polishing damages on a wafer surface, if the processing is performed by using an ammonia hydrogen peroxide-type processing liquid for a certain period of time, and as the result, the number of LPD is rapidly increased (extraordinarily increased). If polishing damages are large, the number of LPD is extraordinarily increased in the early step of a processing time.

Specifically, the evaluation was performed by etching a wafer surface for a certain period of time (20 minutes in the present example) with a processing liquid composed of ammonia, hydrogen peroxide and water, and then counting the number of LPD of 0,12*µ*m or more formed on the wafer surface by a particle counter LS6000 (made by Hitachi Electronics Engineering Co., Ltd.). By repeating such an operation of counting LPDs after etching process for a certain period of time, the alteration of the number of LPD based on the processing time (processing number of times) was evaluated. In this case, the processing liquid was composed of ammonia whose concentration was 0.3 weight %, hydrogen peroxide whose concentration was 0.15 weight %, and a purified water used as the rest.

The results of the evaluation was as follows.

In the polishing pad A (Example 1), the number of LPD was 13.5 particles/cm² when the processing time was 120 minutes (20-minutes processing was repeated 6 times), and after that, the number of LPD was about 25.7 particles/cm² when the processing time was 140 minutes. In the polishing pad B (Example 2), the number of LPD nearly equal to the polishing pad A was detected, however, the increase of the LPD in the case of the polishing pad B having less content of zinc compounds in the wafer surface was smaller than that of the LDP in the case of the polishing pad A.

### Comparative example

Next, a polishing was performed by using a conventionally used polishing pad. The content of zinc compounds in a surface layer of conventionally used polishing pads is generally about 300-800ppm at the ratio of zinc weight relative to the weight of the surface layer of the polishing pad, or 1000ppm or more in the case of a plenty one.

The content of zinc compounds in a surface layer of these polishing pads is approximately consistent in each kind of polishing pads or each of production batches, but the contents have not been controlled.

Consequently, a finish polishing was performed on the same condition as Example 1 by using a conventional polishing pad (zinc content in a surface layer of the polishing pad was 1008pm, and zinc content in the polishing pad was 2500ppm; polishing pad D; Comparative example).

In the polishing pad D (Comparative Example), the number of LPD after polishing the wafer was already increased up to 27.6 particles/cm² when the processing time was 120 minutes, and after that, the number of LPD was increased up to 53.5 particles/cm² when the processing time was 140 minutes.

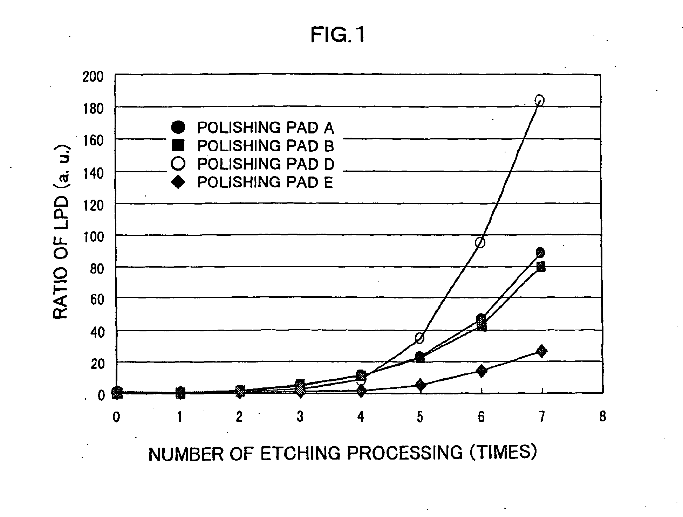

The relation between the number of etching and the ratio of LPD in each polishing pad used in Examples 1 and 2 and Comparative Example is shown in FIG. 1. ,

In this graph, an abscissa axis indicates the number of etching process performed by using an ammonia-type processing liquid (substantially corresponding to processing time), and an ordinate axis indicates the ratio of LPD (substantially corresponding to the number of LPD) on the basis of a case of the polishing pad B (wherein the number of LPD after round of 7 times processes is regarded as 80). Incidentally, FIG. 1 also includes the results of Example 3 (polishing pad E) described later.

It is clear from the graph that as compared a Comparative example (polishing pad D) with Examples 1 and 2 (polishing pads A and B), the content of zinc compounds in the surface layer affects the increase of the number of LPD. Namely, in the case of using the polishing pad D, it is observed that LPDs are increased about twice as many as the case of using the polishing pad A or B. It is clear that the difference of damages existing in the wafer surface is due to the difference of the content of zinc compounds included in the polishing pad, especially in the surface layer of the polishing pad.

Also, it is expected that there are also defects induced by these damages. Actually, wafers polished by the same type polishing pad as the polishing pad D of Comparative example had the higher probability of the generation of defects or decrease of yield in a device fabrication step.

### Example 3

Next, on the same condition as Example 1, a polishing was performed by using a polishing pad having no zinc compounds, specifically a polishing pad having zinc compounds of the lower limit of detection (10ppm) or less detected by the aforementioned Zn content evaluation method.

As to the content of zinc compounds in the polishing pad, the concentration of zinc in a raw material of the polishing pad was determined in a production step of polyurethane, and the polishing pad, which was produced on the condition that the concentration of zinc was controlled to be the lower limit of detection, was used. Also, the addition of zinc compounds or the like was not performed. Thus produced polishing pad has no problem of its physical characteristics (such as hardness).

Although there exists a question of measurement accuracy, the content of zinc in the surface layer and the content of zinc in the polishing pad were determined, and accordingly the content of zinc in the surface layer was about 1ppm, and the content of zinc in the polishing pad was about 2.5ppm (polishing pad E, Example 3).

As to damages on the wafer surface after polishing by using the polishing pad E on the same condition as the aforementioned Examples 1 and 2, as shown in FIG. 1, the number of LPD in the case of the polishing pad E was much smaller than that of LPD in the case of the polishing pad B, and it was about 30 percent of the latter when the processing was repeated seven times. That is, it is found that the increase of the number of LPD was very little, and therefore the wafer having little polishing damages was manufactured.

### (Test)

Further, in a finish polishing step commonly performed at present, only a polishing pad has zinc compounds, and accordingly it has little possibility that zinc compounds come from the outside factor such as a polishing agent.

Therefore, if a control of polishing pads is performed, it will be sufficient, however, for example, the influence where zinc compounds would come from the outside was determined. That is, a polishing was performed with a polishing agent intentionally including zinc oxides. Specifically, the polishing was performed with the polishing agent including zinc oxides (particle diameter was 500nm or more) of about 3mg in the polishing agent of 1 liter.

As the result of this, the considerable number of polishing damages was observed. That is, it is clear that the amount of zinc compounds in the portion where a wafer is in contact with zinc compounds during polishing is important. Namely, polishing damages are also generated on the condition that zinc compounds come from anywhere except a polishing pad, therefore, it is important that the concentration of zinc compounds in the portion with which the wafer is in contact is controlled. Conversely, if a polishing is performed by controlling the concentration of zinc compounds in that portion, polishing damages can be suppressed.

The present invention is not limited to the above-described embodiments. For example, in the above-described embodiments, a single-side polishing apparatus is mainly used, but a double-side polishing apparatus can be also used. That is, the polishing pad and polishing method according to the present invention can be applied to all of apparatuses for polishing a wafer.

Further, as to types of polishing, the present invention is not limited to a single wafer processing which polishes wafers one by one, and thus can be applied to all processing types including batch processing which polishes a plurality of wafers simultaneously.

## Claims

1. A polishing pad used for polishing a semiconductor wafer in a mirror polishing process, **characterized in that** a content of zinc compounds included in the polishing pad is 200ppm or less at the ratio of zinc weight relative to the weight of the polishing pad.

2. A polishing pad used for polishing a semiconductor wafer in a finish polishing process, **characterized in that** a content of zinc compounds included in the polishing pad is 100ppm or less at the ratio of zinc weight relative to the weight of the polishing pad.

3. A polishing pad used for polishing a semiconductor wafer in a finish polishing, **characterized in that** the polishing pad does not include zinc compounds.

4. The polishing pad used for polishing a semiconductor wafer according to any one of Claims 1 - 3, **characterized by** comprising a base layer formed of nonwoven fabric and a porous surface layer.

5. The polishing pad used for polishing a semiconductor wafer according to Claim 4, **characterized in that** a content of zinc compounds in the surface layer is 100ppm or less at the ratio of zinc weight relative to the weight of the polishing pad.

6. A polishing pad used for polishing a semiconductor in a mirror polishing process, **characterized in that** it is comprises a base layer formed of nonwoven fabric and a porous surface layer, and a content of zinc compounds included in the surface layer is 100ppm or less at the ratio of zinc weight relative to the weight of the surface layer.

7. The polishing pad for polishing a semiconductor wafer according to claim 6, **characterized in that** the surface layer does not include zinc compounds.

8. The polishing pad for a semiconductor wafer according to any one of Claims 4-7, **characterized in that** the surface layer is foamed of foamed polyurethane.

9. A method for polishing a semiconductor wafer, **characterized in that** the polishing is performed by using the polishing pad according to any one of claims 1-8.

10. A method for polishing a semiconductor wafer, **characterized in that** the finish polishing is performed while a concentration of zinc compounds is kept to 200ppm or less in the position where the semiconductor wafer is in contact with the polishing pad.

## Patentansprüche

1. Ein Polierkissen, das zum Polieren eines Halbleiterwafers in einem Hochglanzpoliervorgang verwendet wird, **dadurch gekennzeichnet, dass** ein in dem Polierkissen umfasster Gehalt an Zinkverbindungen im Verhältnis von Zinkgewicht relativ zu dem Gewicht des Polierkissens 200 ppm oder weniger beträgt.

2. Ein Polierkissen, das zum Polieren eines Halbleiterwafers in einem Endpoliervorgang verwendet wird, **dadurch gekennzeichnet, dass** ein in dem Polierkissen umfasster Gehalt an Zinkverbindungen im Verhältnis von Zinkgewicht relativ zu dem Gewicht des Polierkissens 100 ppm oder weniger beträgt.

3. Ein Polierkissen, das bei einer Endpolitur zum Polieren eines Halbleiterwafers verwendet wird, **dadurch gekennzeichnet, dass** das Polierkissen keine Zinkverbindungen umfasst.

4. Polierkissen, das zum Polieren eines Halbleiterwafers gemäß einem der Ansprüche 1-3 verwendet wird, **dadurch gekennzeichnet, dass** es eine Basisschicht, die aus Vliesstoff gebildet ist, und eine poröse Oberflächenschicht beinhaltet.

5. Polierkissen, das zum Polieren eines Halbleiterwafers gemäß Anspruch 4 verwendet wird, **dadurch gekennzeichnet, dass** ein Gehalt an Zinkverbindungen in der Oberflächenschicht im Verhältnis von Zinkgewicht relativ zu dem Gewicht des Polierkissens 100 ppm oder weniger beträgt.

6. Polierkissen, das zum Polieren eines Halbleiterwafers in einem Hochglanzpoliturvorgang verwendet wird, **dadurch gekennzeichnet, dass** es eine Basisschicht, die aus Vliesstoff gebildet ist, und eine poröse Oberflächenschicht beinhaltet, und ein Gehalt an in der Oberflächenschicht umfassten Zinkverbindungen im Verhältnis von Zinkgewicht relativ zu dem Gewicht der Oberflächenschicht 100 ppm oder weniger beträgt.

7. Polierkissen zum Polieren eines Halbleiterwafers gemäß Anspruch 6, **dadurch gekennzeichnet, dass** die Oberflächenschicht keine Zinkverbindungen umfasst.

8. Polierkissen für einen Halbleiterwafer gemäß einem der Ansprüche 4-7, **dadurch gekennzeichnet, dass** die Oberflächenschicht aus geschäumtem Polyurethan geschäumt wird.

9. Ein Verfahren zum Polieren eines Halbleiterwafers, **dadurch gekennzeichnet, dass** das Polieren unter Verwendung des Polierkissens gemäß einem der Ansprüche 1-8 durchgeführt wird.

10. Verfahren zum Polieren eines Halbleiterwafers, **dadurch gekennzeichnet, dass** die Endpolitur durchgeführt wird, während eine Konzentration von Zinkverbindungen in der Position, in der der Halbleiterwafer mit dem Polierkissen in Kontakt ist, bei 200 ppm oder weniger gehalten wird.

## Revendications

1. Un tampon à polir utilisé pour polir une plaque de semi-conducteur dans un processus de polissage optique, **caractérisé en ce qu'**un contenu de composés de zinc inclus dans le tampon à polir est de 200 ppm ou moins calculé sur la base du rapport poids du zinc / poids du tampon à polir.

2. Un tampon à polir utilisé pour polir une plaque de semi-conducteur dans un processus de polissage optique, **caractérisé en ce qu'**un contenu de composés de zinc inclus dans le tampon à polir est de 100 ppm ou moins calculé sur la base du rapport poids du zinc / poids du tampon à polir.

3. Un tampon à polir utilisé pour polir une plaque de semi-conducteur dans un polissage de finition, **caractérisé en ce que** le tampon à polir n'inclut pas de composés de zinc.

4. Le tampon à polir utilisé pour polir une plaque de semi-conducteur selon n'importe laquelle des revendications 1 à 3, **caractérisé en ce qu'**il comprend une couche de base formée en un tissu non tissé et une couche de surface poreuse.

5. Le tampon à polir utilisé pour polir une plaque de semi-conducteur selon la revendication 4, **caractérisé en ce qu'**un contenu de composés de zinc dans la couche de surface est de 100 ppm ou moins sur la base du rapport poids du zinc / poids du tampon à polir.

6. Un tampon à polir utilisé pour polir un semi-conducteur dans un processus de polissage optique, **caractérisé en ce qu'**il comprend une couche de base formée en un tissu non tissé et une couche de surface poreuse, et un contenu de composés de zinc inclus dans la couche de surface est de 100 ppm ou moins calculé sur la base du rapport poids du zinc / poids de la couche de surface.

7. Le tampon à polir destiné à polir une plaque de semi-conducteur selon la revendication 6, **caractérisé en ce que** la couche de surface n'inclut pas de composés de zinc.

8. Le tampon à polir destiné à une plaque de semi-conducteur selon n'importe laquelle des revendications 4 à 7, **caractérisé en ce que** la couche de surface est formée de polyuréthane alvéolé.

9. Une méthode destinée à polir une plaque de semi-conducteur, **caractérisée en ce que** le polissage est effectué en utilisant le tampon à polir selon n'importe laquelle des revendications 1 à 8.

10. Une méthode destinée à polir une plaque de semi-conducteur, **caractérisée en ce que** le polissage de finition est effectué tandis qu'une concentration en composés de zinc est maintenue à 200 ppm ou moins dans la position où la plaque de semi-conducteur est en contact avec le tampon à polir.
